# EUROPEAN PATENT APPLICATION

(11) **EP 1 292 023 A2**
(43) Date of publication of application: **12.03.2003**
(21) Application number: 02019390.0
(22) Date of filing: 29.08.2002
(51) Int. Cl.: H03H 3/10, H03H 9/02

(54) **Method for adjusting the temperature-dependent property of a surface acoustic wave device**

(30) Priority: 29.08.2001 JP 2001260122; 05.06.2002 JP 2001164912
(71) Applicant: SEIKO EPSON CORPORATION, Shinjuku-ku, Tokyo 163-0811 (JP)
(72) Inventor: Iizawa, Keigo, c/o Seiko Epson Corporation, Suwa-shi, Nagano-ken 392-8502 (JP); Yamazaki, Takashi, c/o Seiko Epson Corporation, Suwa-shi, Nagano-ken 392-8502 (JP); Kanna, Shigeo, c/o Seiko Epson Corporation, Suwa-shi, Nagano-ken 392-8502 (JP)
(74) Representative: Hoffmann, Eckart, Dipl.-Ing.

(57) **Abstract**

A method for adjusting the temperature-dependent property of a SAW device is provided, the method being appropriate to the temperature-dependent property expressed by a cubic function of a SAW device using an rotated ST cut quartz crystal plate. The range of Euler's angles is defined so that the temperature-dependent property of the SAW device using an in-plane rotated ST cut quartz crystal plate having the temperature-dependent property expressed by a cubic function has an extreme value within the temperature range of -40 to +85 °C, and the temperature-dependent property curve is rotated about the inflection point to minimize the frequency fluctuation within the operation temperature range by using predefined regions.

## Description

The present invention relates to a method of adjusting the temperature-dependent property of a surface acoustic wave device using an in-plane rotated ST cut quartz crystal plate.

Conventional quartz crystal piezoelectric resonators have a temperature-dependent property (e.g., the frequency changes in association with temperature changes), and the property may be expressed by a quadratic function such as that of tuning fork type resonators and surface acoustic wave device, or by a cubic function such as that of AT resonators.

The temperature-dependent property of a piezoelectric resonator is adjusted so that the frequency fluctuation is minimized in the operation temperature range (-40 to +85 °C) including a normal operation temperature of 25°C. In a piezoelectric resonator having the temperature-dependent property expressed by a quadratic function, the peak temperature (the temperature associated with an extreme value of frequency) is centered in the operation temperature range so that the frequency fluctuation is minimized. Conventional piezoelectric resonators having the temperature-dependent property expressed by a quadratic function have the peak temperature in the range of 0°C to 50°C.

The temperature-dependent property of an AT cut resonator, expressed by a cubic function, causes a limited frequency fluctuation in the operation temperature range because the temperature at the inflection point is located almost at the center of the operation temperature range.

Surface acoustic wave (SAW) devices, typically a SAW resonator or a SAW filter, sometimes use an in-plane rotated ST cut quartz crystal plate (simply referred to as "rotated crystal plate" hereinafter) for the purpose of reducing temperature dependent frequency fluctuations.

The SAW device using a rotated crystal plate is traditionally believed to have a temperature-dependent property expressed by a quadratic function as is the case with the SAW device using a conventional ST cut quartz crystal plate. Therefore, the peak temperature of the SAW device using a rotated crystal plate coincides with the center of the operation temperature range so as to minimize the frequency fluctuation associated with temperature changes. However, recent studies by the present inventors proved the temperature-dependent property is actually expressed by a cubic function of the temperature having an inflection point nearly at 110°C. In general, measurements of the temperature-dependent property are not obtained for temperatures that greatly exceed 110°C. This explains why it has not been found that the SAW device using a rotated crystal plate has a temperature-dependent property expressed by a cubic function. An adjustment of the temperature-dependent property of a SAW device using a rotated crystal plate is conventionally based on the assumption of a quadratic function; therefore, it actually fails to optimize the frequency fluctuation in the operation temperature range.

Here, a problem arises that conventional adjustment techniques do not substantially optimize the temperature-dependent property of a SAW device using a rotated crystal plate since it has the temperature-dependent property expressed by a cubic function, not by a quadratic function.

In view of the problem described above, the present invention seeks to provide a method for adjusting the temperature-dependent property of a SAW device, the method being suitable to the temperature-dependent property expressed by a cubic function of a SAW device using a rotated crystal plate.

This object is achieved by a method as claimed in claim 1. Preferred embodiments of the invention are subject-matter of the dependent claims.

The present invention is based on the finding that the SAW device using a rotated crystal plate actually has a temperature-dependent property expressed by a cubic function of the temperature and, therefore, the peak temperature can be shifted from the center of the operation temperature range to further reduce the frequency fluctuation, although it is traditionally considered to have a temperature-dependent property expressed by a quadratic function and, therefore, the peak temperature is arranged to locate the center of the operation temperature range.

A method for adjusting the temperature-dependent property of a SAW device according to the present invention uses a rotated crystal plate having Euler's angles of (0°, 113 - 135°, ±(40 - 49°)), wherein the temperature-dependent property of the SAW device using the rotated crystal plate having the temperature-dependent property expressed by a cubic function is adjusted by rotating temperature-dependent property curve about the inflection point. The range of the Euler's angles is determined so that the temperature-dependent property of the SAW device has an extreme value and, then, the temperature-dependent property curve is rotated about the inflection point to minimize fluctuation of the temperature-dependent property in the operation temperature range.

When the Euler's angles are (0°, θ, ψ), ψ is in the following range: ψ = 0.3295 θ + 3.3318° ± 1.125°.

In particular, when the Euler's angles are (0°, θ, ψ), it is preferred that θ = 125 - 128°, and η (electrode width/electrode pitch) is 0.3 - 0.6.

The temperature-dependent property around the inflection point is adjusted by modifying the thickness of the electrode deposits of the SAW device. Alternatively, it is adjusted by modifying the rotation of the quartz crystal in a plane about the Z' axis. Further alternatively, it is adjusted by modifying η (electrode width/electrode pitch) of the electrodes of the SAW device. A SAW device of the present invention is manufactured by the method described above.

As is described above, it has been found by the present inventors that a SAW device using a rotated crystal plate having the Euler's angles of (0°, 113 - 135°, ±(40 - 49°)) has a temperature-dependent property expressed by a cubic function. When the range of the Euler's angles corresponds to the temperature-dependent property having an extreme value of a cubic function, it is determined within the range (0°, 113 - 135°, ±(40 - 49°)). Then, the temperature-dependent property curve is rotated about the inflection point defined by the cubic function within the above range to minimize fluctuation of the temperature-dependent property (i.e. frequency fluctuation) in the operation temperature range. In particular, with θ of the Euler's angles being 125 - 128° and η (electrode width/electrode pitch) being 0.3 - 0.6, the frequency fluctuation can be minimized in the temperature range of -40 to +85 °C, even taking into account a fluctuation of the temperature-dependent property due to a manufacturing error that has a larger influence on higher frequencies. The temperature-dependent property around the inflection point is modified by adjusting the rotation of the quartz crystal in a plane about the Z' axis or by adjusting the thickness or width of the electrode deposits formed on the surface.

The ranges of the Euler's angles in which the temperature-dependent property expressed by a cubic function has an extreme value have been verified by the present inventors as is defined in Claim 3. Therefore, this range can be targeted in modifying the rotation of a plane.

Embodiments of the method for adjusting the temperature-dependent property of a SAW device and the SAW device of the present invention are hereinafter described with reference to the drawings.
- Fig. 1: is an illustration to show a rotated crystal plate rotated about the Z' axis.
- Fig. 2: is a graphical representation to show the temperature-dependent property curve of a SAW device using a rotated crystal plate rotated about the Z' axis.
- Fig. 3: is a graphical representation to show the range in which the temperature-dependent property curve having an extreme value is easily found for a rotated crystal plate having the Euler's angles of (0, 113- 135°, ±(40 - 49°)).
- Figs. 4: to 8 are graphical representations to verify that the cubic function has/does not have an extreme value for a resonator type SAW device using a rotated crystal plate having the Euler's angles of (0°, 113 - 135°, ±(40 - 49°)).
- Figs. 9: 12 are graphical representations to verify that the cubic function has/does not have an extreme value in a transversal type SAW filter using an rotated crystal plate having the Euler's angles of (0°, 113 - 135°, ±(40 - 49°)).
- Fig. 13: is an illustration to explain the adjustment processes of the temperature-dependent property expressed by a cubic function.
- Fig. 14: is a graphical representation to show the temperature-dependent property of a prior art ST cut resonator type SAW device having the Euler's angles of (0°, 123°, 0°).
- Fig. 15: is a graphical representation to show the temperature-dependent property of an in-plane rotated ST cut resonator type SAW device having θ = 123°, H/λ = 0.05, η = 0.4 according to an embodiment.
- Fig. 16: is a graphical representation to show the temperature-dependent property of an in-plane rotated ST cut resonator type SAW device having θ = 123°, H/λ = 0.05, η = 0.3 according to an embodiment.
- Fig. 17: is a graphical representation to show the temperature-dependent property of an in-plane rotated ST cut resonator type SAW device having θ = 123°, H/λ = 0.05, η = 0.5 according to an embodiment.
- Fig. 18: is a graphical representation to show the relationship between θ and the maximum frequency fluctuation within the temperature range of -40 to + 85 °C of an in-plane rotated ST cut resonator type SAW device having H/λ = 0.03, η = 0.4±0.1 according to an embodiment .
- Fig. 19: is a graphical representation to show the relationship between θ and the maximum frequency fluctuation within the temperature range of -40 to + 85 °C of an in-plane rotated ST cut resonator type SAW device having H/λ = 0.03, η = 0.5±0.1 according to an embodiment .
- Fig. 20: is a graphical representation to show the relationship between θ and the maximum frequency fluctuation within the temperature range of -40 to + 85 °C of an in-plane rotated ST cut resonator type SAW device having H/λ = 0.04, η = 0.4±0.1 according to an embodiment .
- Fig. 21: is a graphical representation to show the relationship between θ and the maximum frequency fluctuation within the temperature range of -40 to + 85 °C of an in-plane rotated ST cut resonator type SAW device having H/λ = 0.04, η = 0.5±0.1 according to an embodiment .
- Fig. 22: is a graphical representation to show the relationship between θ and the maximum frequency fluctuation within the temperature range of -40 to + 85 °C of an in-plane rotated ST cut resonator type SAW device having H/λ = 0.05, η = 0.4±0.1 according to an embodiment .
- Fig. 23: is a graphical representation to show the relationship between θ and the maximum frequency fluctuation within the temperature range of -40 to + 85 °C of an in-plane rotated ST cut resonator type SAW device having H/λ = 0.05, η = 0.5±0.1 according to an embodiment.

The SAW device using a rotated crystal plate (in-plane rotated ST cut quartz crystal plate) has a temperature-dependent property expressed by a cubic function while the SAW device using a conventional ST cut quartz crystal plate usually has the temperature-dependent property expressed by a quadratic function. The SAW device having the temperature-dependent property expressed by a cubic function has an inflection point at a higher temperature than the upper limit of the normal operation temperature range. Having the proximity of the local maximum of the temperature-dependent property expressed by the cubic function in the operation temperature range can provide a SAW device with a reduced frequency fluctuation associated with temperature changes.

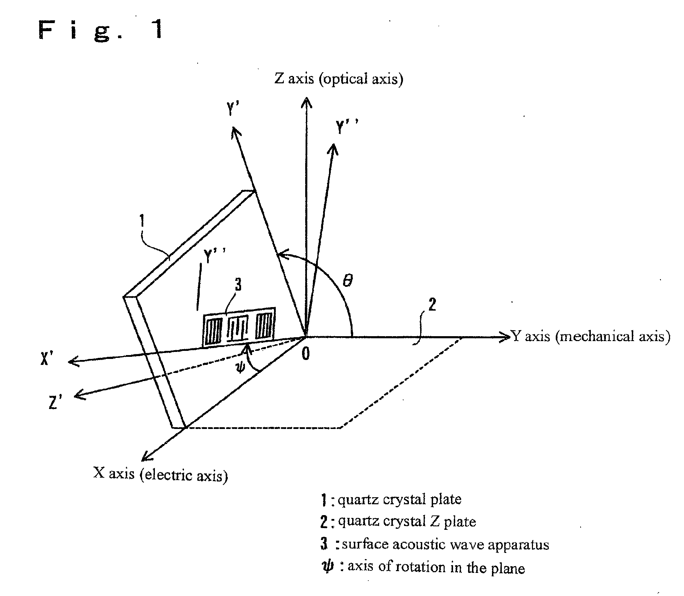

The temperature-dependent property of a piezoelectric resonator is determined by the direction in which it is cut out of a quartz crystal. Quartz crystal has electric (X), mechanical (Y), and optical (Z) axes as shown in Fig. 1. A quartz crystal Z plate 2 having the Euler's angles (φ, θ, ψ) of (0°, 0°, 0°) is rotated by θ = 113 - 135° about the electric axis (X axis) to obtain a quartz crystal plate 1. Then, the quartz crystal plate 1 has the new axes (X, Y', Z'), along which a ST cut is made. The ST cut quartz crystal 1 is further rotated by ψ = ±(40 - 49°) about the Z' axis to obtain a piezoelectric resonator having a surface acoustic wave propagation direction defined by this rotation, which is called an in-plane rotated ST cut SAW device 3. The in-plane rotated ST cut SAW device 3 is known for excellent temperature-dependent property. This temperature-dependent property has been considered to be a quadratic function because the device is a type of ST cut. However, studies by the present inventors proved that the temperature-dependent property is actually expressed by a cubic function having an inflection point around 110°C. In general, measurements of the temperature-dependent property are not obtained for temperatures that greatly exceed 110°. This explains why it has not been found that the SAW device using a rotated crystal plate has the temperature-dependent property expressed by a cubic function. Adjustment of the temperature-dependent property of a SAW device using a rotated crystal plate conventionally is based on a quadratic function; therefore, it actually fails to optimize frequency fluctuation in the operation temperature range.

With the finding that the in-plane rotated ST cut SAW device has the temperature-dependent property expressed by a cubic function, the term having the first-order coefficient in the cubic function is adjusted to rotate the temperature-dependent property curve about the inflection point that is outside the operation temperature range so that the peak temperature, which is the temperature with the local maximum or local minimum within the operation temperature range, is adjusted to the optimum value in the operation temperature range. In more detail, a quartz crystal plate is rotated by θ = 113 - 135° about the electric axis (X axis) to obtain a ST cut quartz crystal plate, which is further rotated by ψ = ±(40 - 49°) in the plane about the Z' axis. Within this range, a range is selected such that the temperature-dependent property has an extreme value within the operation temperature range of -40 to +85 °C. The rotation in the plane is modified within this range giving an extreme value to coincide the local maximum or local minimum of the temperature-dependent property with the optimum temperature within the operation temperature.

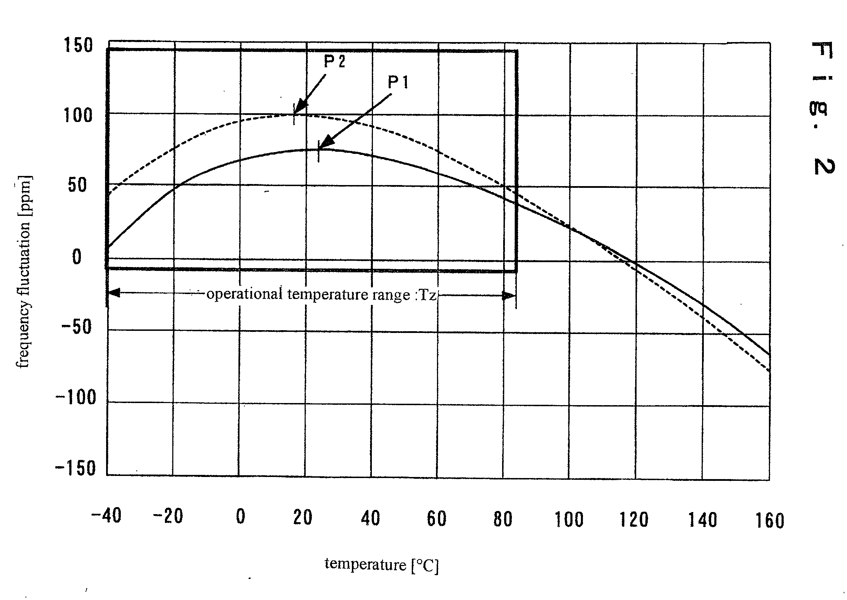

As is shown in Fig. 2, the temperature-dependent property of an in-plane rotated ST cut SAW device has an inflection point temperature at approximately 110°C. The operation temperature range is -40 to +85 °C, which is lower than the inflection point temperature. On the temperature-dependent property curve of a cubic function, a temperature range including a local maximum at a lower temperature than the inflection point temperature is employed (portion in Fig. 2 enclosed by a square). The inflection point of the temperature-dependent property expressed by a cubic function is barely modified. Therefore, the term of the cubic function having the first order coefficient is adjusted to rotate the temperature-dependent property curve about the inflection point. In this way, the local maximum of the temperature-dependent property curve within the operation temperature range is moved to lower temperatures than the center of the operation temperature range. The temperature-dependent property curve shown by the solid line in Fig. 2 has the local maximum P1 at the center of the operation temperature range Tz. This is obtained by the prior art adjustment in which the temperature-dependent property is treated as a quadratic function. After the temperature-dependent property curve is rotated about the inflection point, the result of which is shown by the broken line, the local maximum temperature is moved to P2 from P1. This can minimize the frequency fluctuation within the operation temperate range.

A rotated ST cut SAW device is manufactured as follows. First, a ST cut quartz crystal wafer is prepared. An in-plane rotated angle ϕ is given by the orientation flat, along which reflection electrodes (referred to as "reflector") and fingers-interleaved electrodes (referred to as "IDT (interdigital transducer )") are provided on the resonating regions by lithographic techniques. In practice, the temperature-dependent property expressed by a cubic function is adjusted by modifying the rotation angle ψ = ±(40 - 49°) in the plane to change the surface acoustic wave propagation direction. The relationship between changes in ψ and in the term having the first order coefficient of the temperature-dependent property expressed by a cubic function is known. Therefore, the direction and magnitude are predictable for the adjustment. An in-plane rotated ST cut SAW device is created and its temperature-dependent property is analyzed. The rotation magnitude is determined so that the local maximum (or local minimum) shifts to lower temperatures than the center of the designed operation temperature range. Then, ψ is calculated according to the rotational magnitude. Then, the orientation flat corresponding to the rotation angle ψ in the plane is determined in the range of ±(40 - 49°) to create reflectors and IDT. In this way, an in-plane rotated ST cut SAW device with minimized frequency fluctuation within the operation temperature range is obtained.

Fig. 3 is a graphical representation to show the range in which a possible temperature-dependent property curve having an extreme value is easily found for a rotated crystal plate having the Euler's angles of (0°, 113 - 135°, ±(40 - 49°)).

Studies by the present inventors found the ranges of θ and ψ that facilitate the finding, in the range having the temperature-dependent property expressed by a cubic function shown in Fig. 3, of the temperature-dependent property curve having an extreme value (local maximum or local minimum) within the temperature range of -40 to +85 °C for a transversal type SAW device. These ranges are shown by the cross-hatched region 5 in Fig. 3. The hatched region 4 shows additional ranges of θ and ψ that help to find a temperature-dependent property curve having an extreme value (local maximum or local minimum) within the temperature range above for a resonator-type SAW device, but does not overlap the cross-hatched region 5. The values of ψ are smaller compared to those of the cross-hatched region 5 for the electrodes formed. The combined region 4 and 5 is defined by the following expression (1):$\text{ψ = 0.3295 θ + 3.3318° ± 1.125°}$

Rotation in a plane about the Z' axis within the region indicated by the hatched regions 4 and 5 leads to find the temperature-dependent property curve having an extreme value (local maximum or local minimum). Then, the temperature-dependent property curve is further rotated about the inflection point to minimize the frequency fluctuation within the operation temperature range.

The temperature-dependent property at the borders of the hatched regions 4 and 5 was studied and the ranges indicated by the hatched regions 4 and 5 have been verified by the present inventors. The SAW device having an in-plane rotated ST cut quartz crystal plate of this embodiment includes a transversal type SAW filter and a resonator type SAW device (such as a SAW resonator, a resonator type SAW filter).

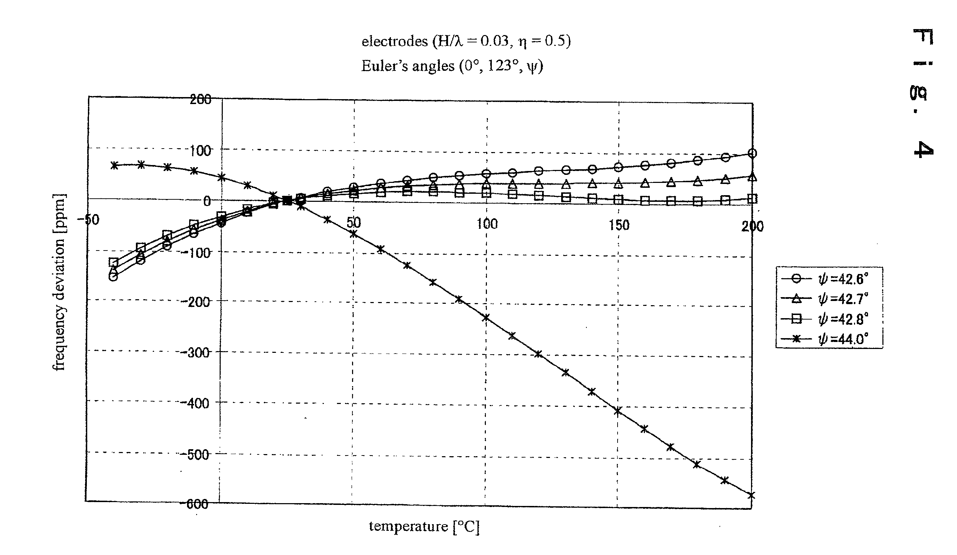

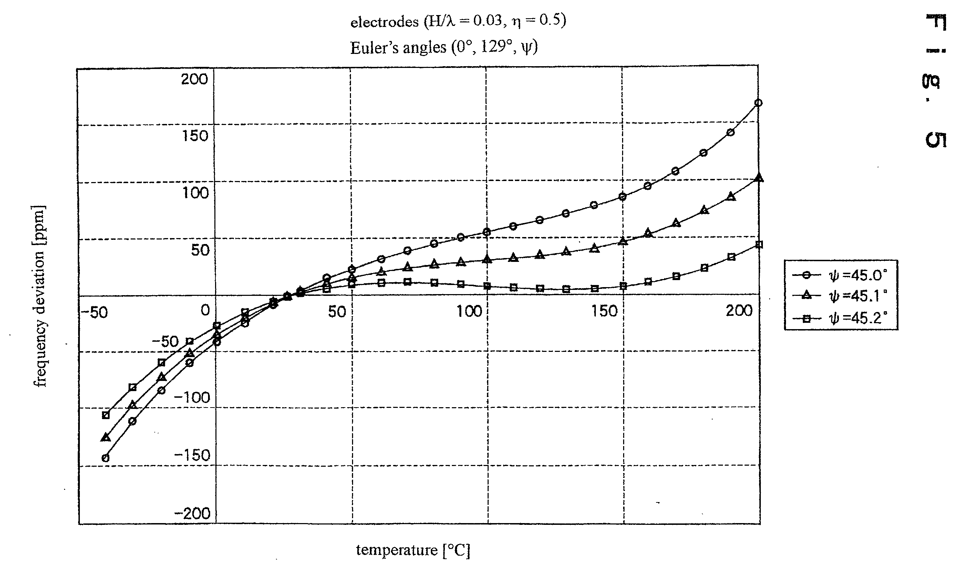

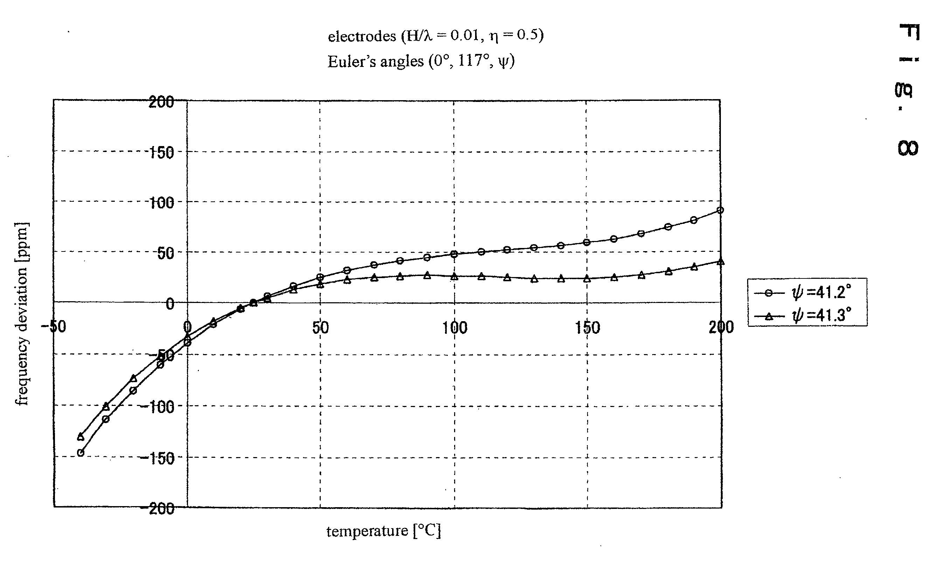

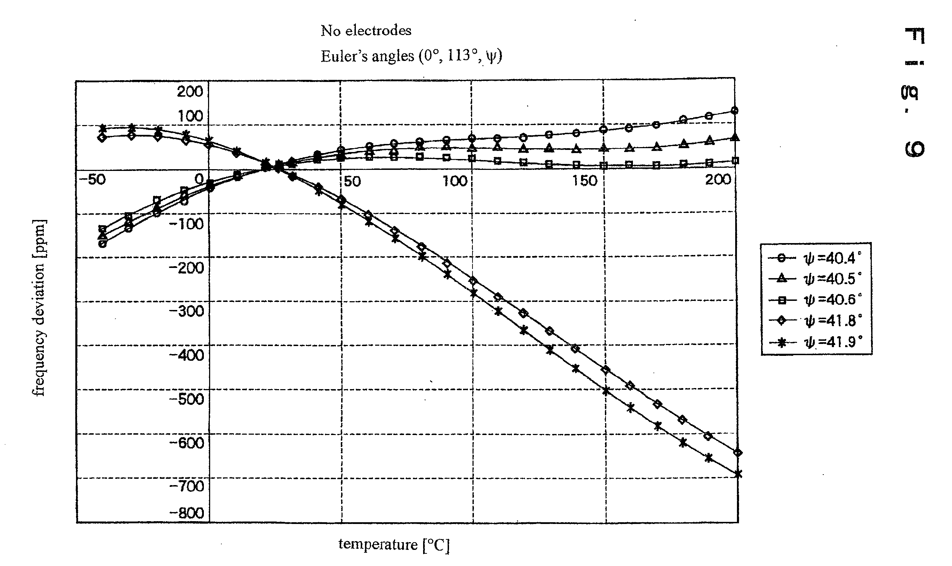

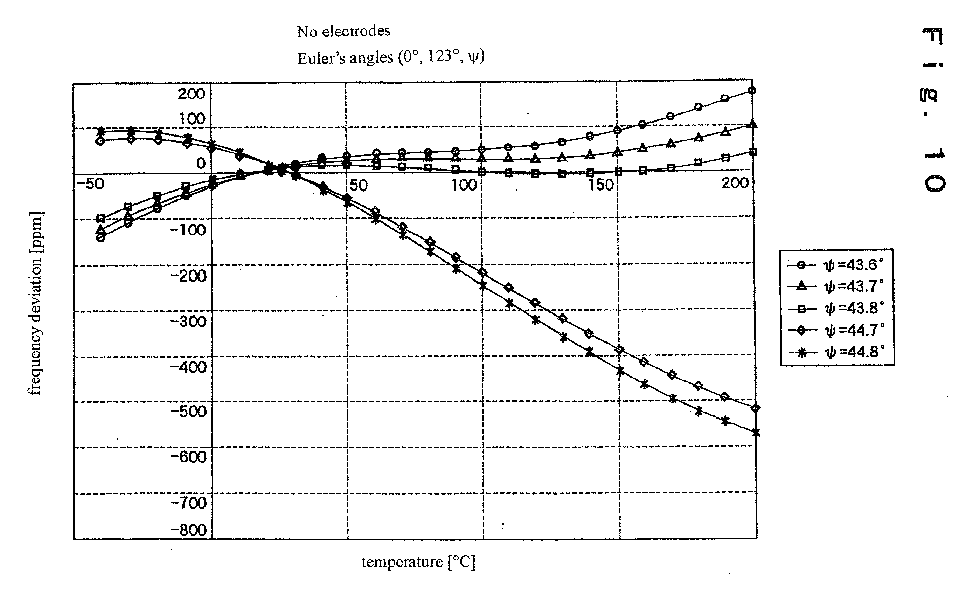

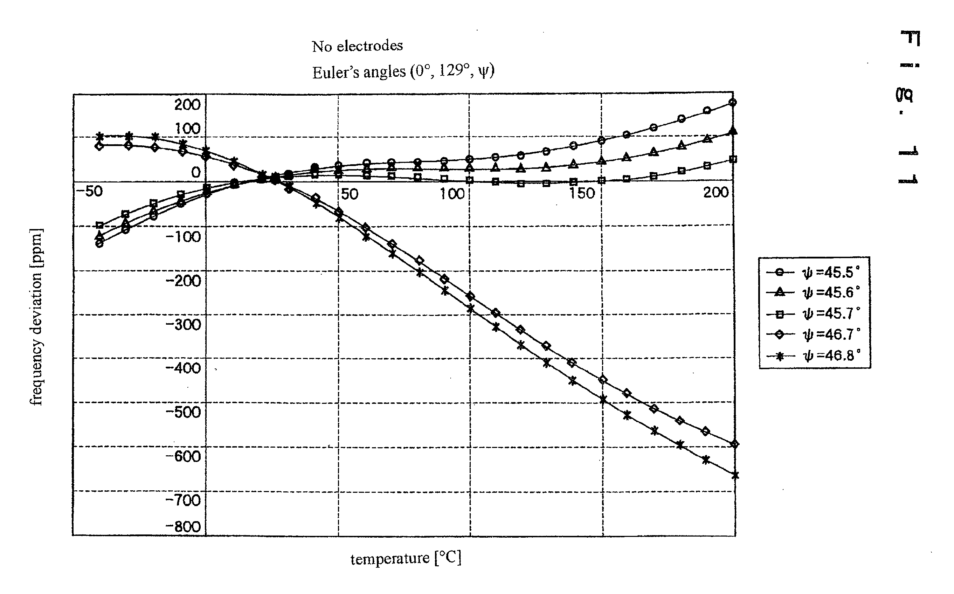

Figs. 9 to 12 are graphical representations to verify that the cubic function has/does not have an extreme value in a transversal type SAW filter using an rotated crystal plate having the Euler's angles of (0°, 113 - 135°, ±(40 - 49°)).

The ranges of θ and ψ are found from these figures that facilitate the finding of the temperature-dependent property having an extreme value (local maximum or local minimum) within the temperature range of -40 to +85 °C for a SAW device of transversal type SAW filter. These ranges are shown by the hatched region 5 in Fig. 3 and defined by the following expression (2):$\text{ψ = 0.3295 θ + 3.8318° ± 0.625°}$

Studies by the present inventors on the temperature-dependent property of a resonator type SAW device besides the temperature-dependent properties of a transversal type SAW filter showed various regularities. A transversal type SAW filter is provided with a transmission IDT electrode (comb electrode) and a reception IDT electrode spaced from each other on the surface of a piezoelectric quartz crystal board. Nothing is present between the IDT electrodes in the SAW filter. The width and thickness of the electrodes hardly affect the temperature-dependent property of frequency (the temperature-dependent property is hardly changed by modifying the electrode form). On the contrary, a resonator type SAW device has an IDT electrode on the surface of a piezoelectric quartz crystal board, on which reflector electrodes are formed to sandwich the IDT electrode. Therefore, the width and thickness of the IDT electrode cause the temperature-dependent property to undergo changes.

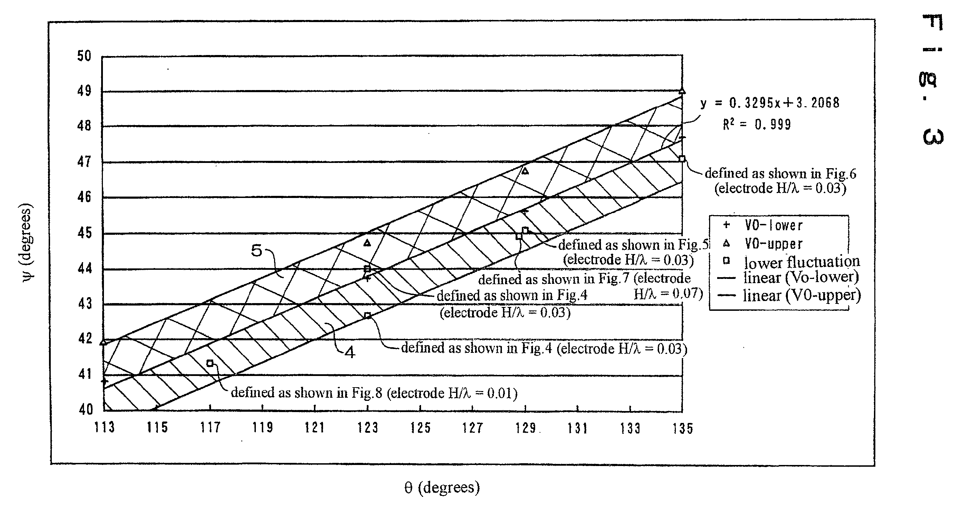

Fig. 4 is a graphical representation to verify that the cubic function has/does not have an extreme value within the temperature range of -40 to +85 °C for a resonator type SAW device using a rotated crystal plate having the Euler's angles of (0°, 123°, ±(40 - 49°)). As is shown in this figure, it is understood that the temperature-dependent property has no extreme values within the temperature range of -40 to +85 °C when the in-plane rotation angle ψ is smaller than the range shown by the hatched region 4 in Fig. 3. It is also understood that Fig. 4 shows the temperature-dependent property has an extreme value when the in-plane rotation angle ψ is larger than shown by the hatched region 4 in Fig. 3 and also shows this is included in the cross-hatched region 5.

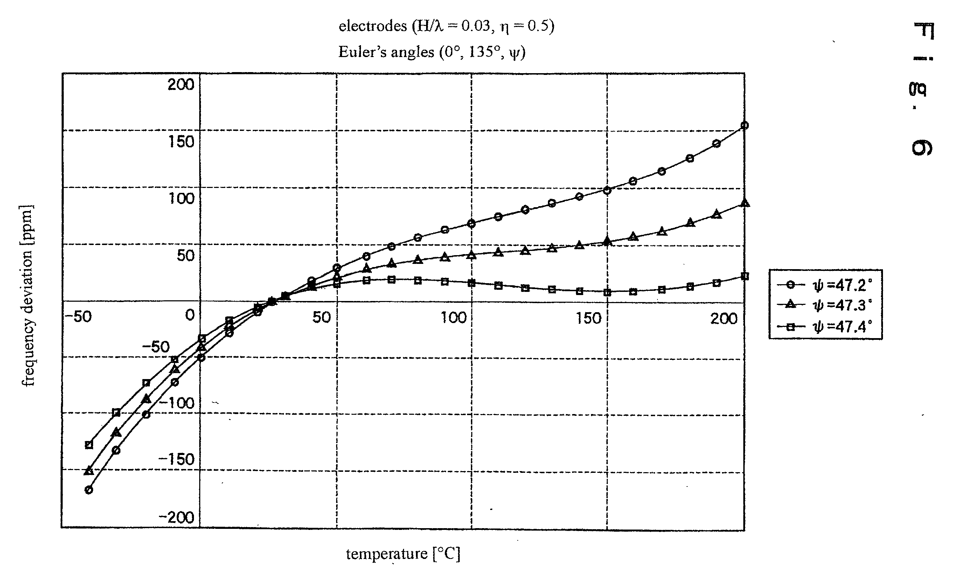

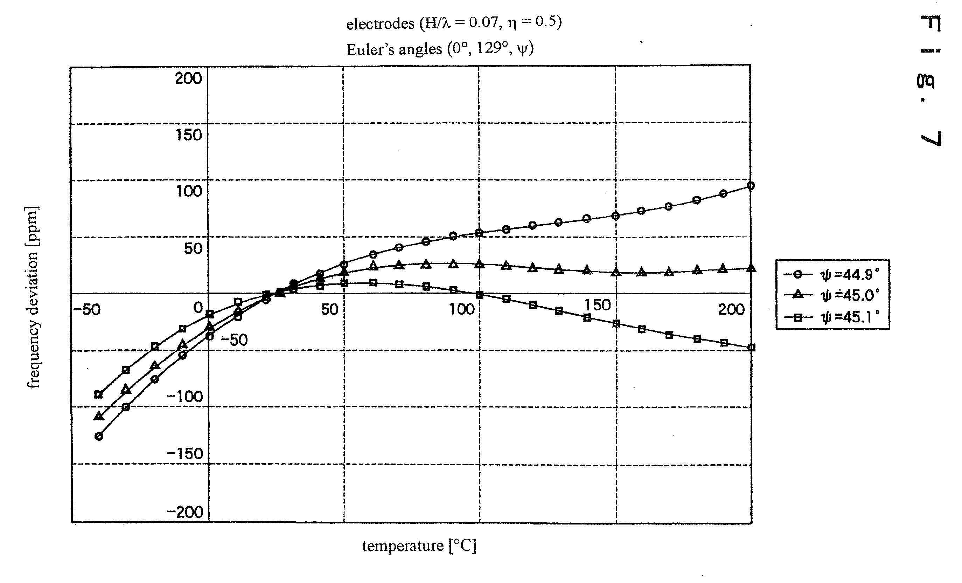

Figs. 4 and 10 show that a similar temperature-dependent property curve is obtained using the same θ, but different ψ for the Euler's angles (0°, θ, ψ) depending on the presence and absence of the electrodes. For instance, the limit value of ψ to give an extreme value is 43.7° in Fig. 10 and 42.7° in Fig. 4, which is smaller by 1 degree. In other words, the presence of electrodes makes it difficult to find the temperature-dependent property having an extreme value (local maximum or local minimum) within the temperature range of -40 to +85 °C by simply using the range of ψ values defined by the cross-hatched region 5 in Fig. 3. Therefore, the range that is extended by 1 degree to smaller values from that defined by the cross-hatched region 5 in Fig. 3 (which is the hatched region 4) is added to the cross-hatched region 5 to facilitate the finding of the temperature-dependent property having an extreme value (local maximum or local minimum) within the temperature range of -40 to +85 °C irrespective of the presence or absence of the electrodes. The combined range of the hatched regions 4 and 5 is defined by the expression 1.

Figs. 5 to 7 and 8 show the temperature-dependent property of a resonator type SAW device having the Euler's angles of (0°, 117°, ψ), (0°, 129°, ψ), and (0°, 135°, ψ). These figures show it is not easy to find the temperature-dependent property having an extreme value (local maximum or local minimum) within the temperature range of -40 to +85 °C by using only the range of ψ defined by the cross-hatched region 5 in Fig. 3; however, the temperature-dependent property having an extreme value (local maximum or local minimum) within the temperature range of -40 to +85 °C is easily found by using the combined region of the hatched regions 4 and 5.

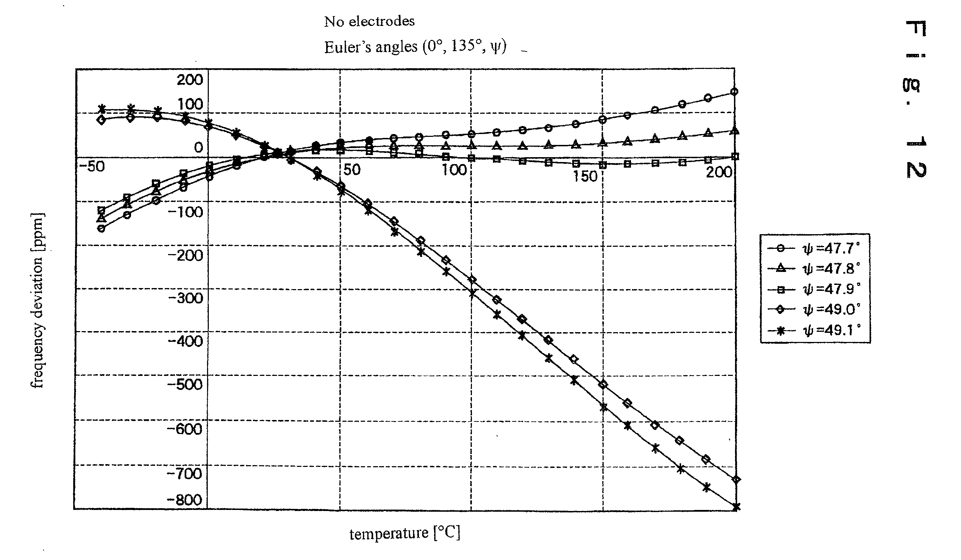

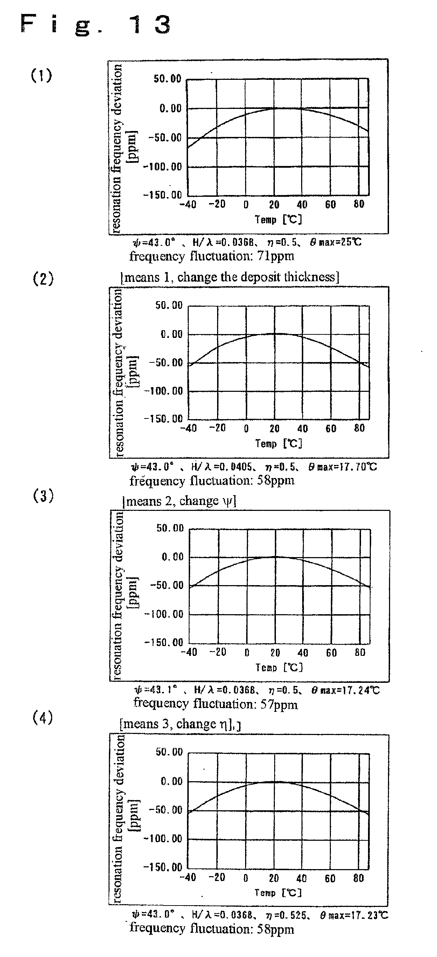

Recognizing the cut angle within the Euler's angles range above which achieves the temperature-dependent property having an extreme value within the temperature range of -40 to +85 °C allows for minimizing the frequency fluctuation within the operation temperature range of a SAW device. As is shown in Fig. 13 (1), a resonator type SAW device complying with the hatched region 4 in Fig. 3 has the peak temperature nearly at the center (25°C) of the operation temperature range of -40 to +85 °C. However, the temperature-dependent property of frequency is expressed by a cubic function in Fig. 13 (1) and, therefore, the frequency fluctuation is not symmetrical about the peak temperature as a reference. To reduce the fluctuation of the temperature-dependent property expressed by a cubic function, the peak temperature should be shifted to a lower temperature so that the frequency fluctuation on either side, higher and lower temperature sides, is the same.

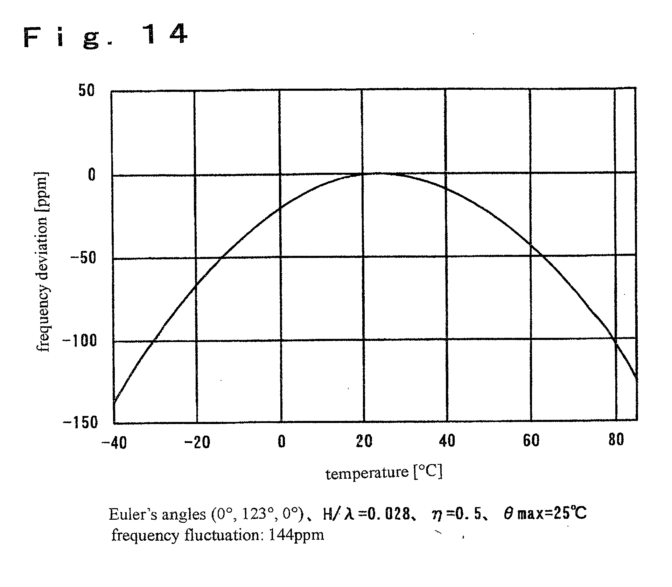

Fig. 13 (1) is an illustration to show the temperature-dependent property of a resonator type SAW device having a rotated crystal plate and having the Euler's angles of (0°, 123°, 43°). Here, the frequency fluctuation can be reduced to 71ppm compared to a conventional ST cut having the Euler's angles of (0°, 123°, 0°) shown in Fig. 14. However, this resonator type SAW device has the peak temperature at 25°C, which is nearly the center of the operation temperature range. The frequency fluctuation can be reduced within the operation temperature range by modifying the peak temperature. To do so, the peak temperature is shifted to the lower temperature side.

A rotated crystal plate has the temperature-dependent property expressed by a cubic function. Rotating the temperature-dependent property curve about the inflection point gives results similar to the peak temperature shift. First, the thickness H of the IDT electrode deposit can be modified to shift the peak temperature shown in Fig. 13 (1) to the lower temperature side. The electrode deposit thickness H is increased so that the deposit thickness ratio H/λ is increased as is shown in Fig. 13 (2). This causes the peak temperature to shift to the lower temperature side thereby adjusting the temperature-dependent property. The rotation in the plane about the Z' axis can be also adjusted to modify the temperature-dependent property around the inflection point. This is realized by modifying the angle that determines the direction along which the electrodes are formed (the surface acoustic wave propagation direction). As is shown in Fig. 13 (3), the rotation angle ψ in the plane about the Z' axis can be changed to ψ = 43.1° from ψ = 43.0°. Furthermore, an adjustment is performed by changing η (electrode width/electrode pitch) of the IDT electrode. This is shown in Fig. 13 (4). Those modifications allow a further reduced frequency fluctuation within the operation temperature range compared to the prior art temperature-dependent property.

The SAW device has smaller electrodes for higher resonance frequencies. The smaller electrodes have smaller widths, which increases manufacturing errors of the electrode width. This leads to a larger deviation in η (electrode width/electrode pitch) that further affects the temperature-dependent property. For instance, η has a manufacturing error of approximately ± 0.1 for 1 GHz. This hampers the steady manufacturing of the SAW device using an rotated crystal plate 1 with a frequency fluctuation of less than 100ppm within the temperature range of -40 to +85 °C when a resonance frequency as high as 1GHz is required.

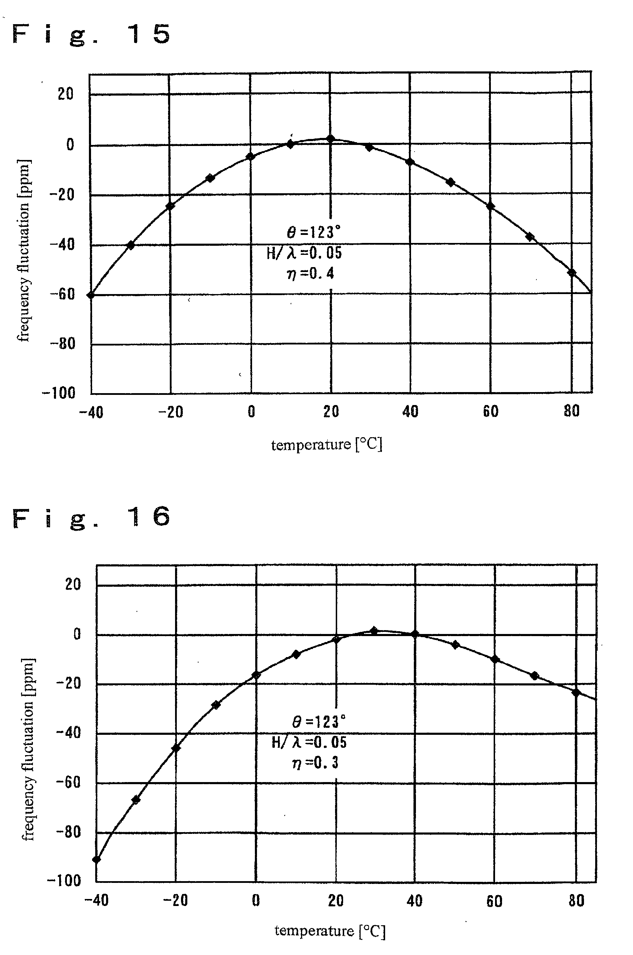

For instance, with a resonator type SAW device using a rotated crystal plate 1 having the Euler's angles of (φ, θ, ψ) wherein φ = 0° and θ =123° and the deposit thickness ratio H/λ = 0.05, η = 0.4, the frequency fluctuation within the operation temperature range of -40 to +85 °C can be adjusted to approximately 60ppm as is shown in Fig. 15. In the case in Fig. 15, ψ is adjusted within the angle range given by the expression 1 to obtain the optimized temperature-dependent property based on the frequency measured at 25°C.

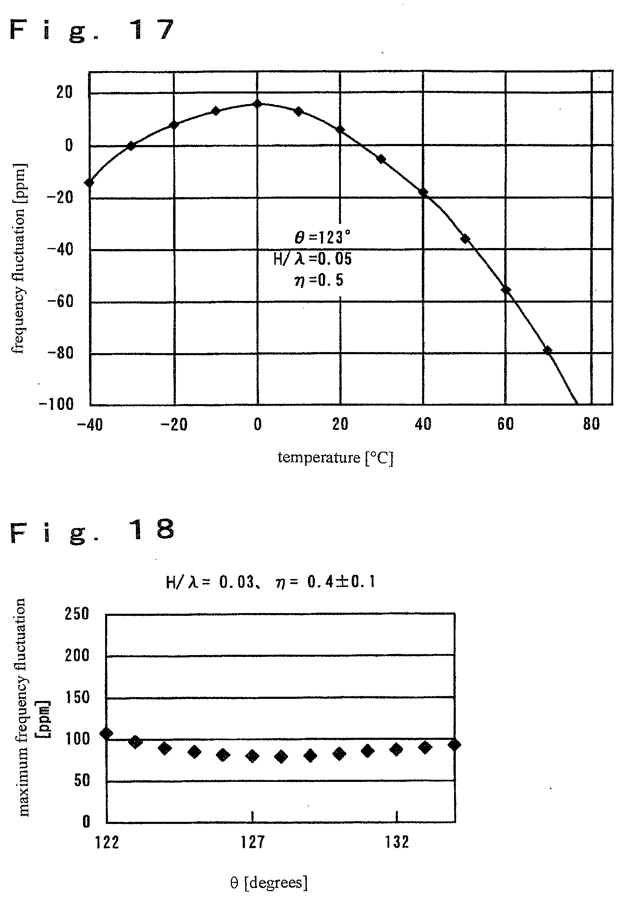

Using the same Euler's angles and deposit thickness ratio, but a smaller electrode width η = 0.3, the frequency fluctuation exceeds 90ppm as is shown in Fig. 16. On the other hand, using the same Euler's angles and deposit thickness ratio, but a larger electrode width η = 0.5, the frequency fluctuation is 134ppm as is shown in Fig. 17 (the frequency fluctuation at 85 °C is not shown in Fig. 17). Therefore, when η = 0.4 is targeted for a frequency fluctuation of less than 100ppm, the manufacturing error of the electrode width causes the resonator type SAW device to have a frequency fluctuation larger than 100ppm.

Studies by the present inventors found the cut angle of a quartz crystal plate that achieves an in-plane rotated ST cut resonator type SAW device having a frequency fluctuation of less than 100ppm within the temperature range of -40 to +85 °C regardless of the manufacturing error of the electrode width. Figs. 18 to 23 show the relationship between θ of the Euler's angles and the deposit thickness ratio (H/λ) and η. The ordinate shows the maximum frequency fluctuation when η changes by ±0.1. For instance, the maximum frequency fluctuation is translated from Fig. 17 that shows the largest maximum frequency fluctuation among Figs. 15 to 17 that show the frequency fluctuation when θ = 123°, H/λ = 0.05, and η = 0.4±0.1, respectively. ψ is the angle range given by the expression 1, which is not shown. In all the cases, the frequency fluctuation in the temperature range of -40 to +85 °C based on the frequency measured at 25°C as a reference is shown.

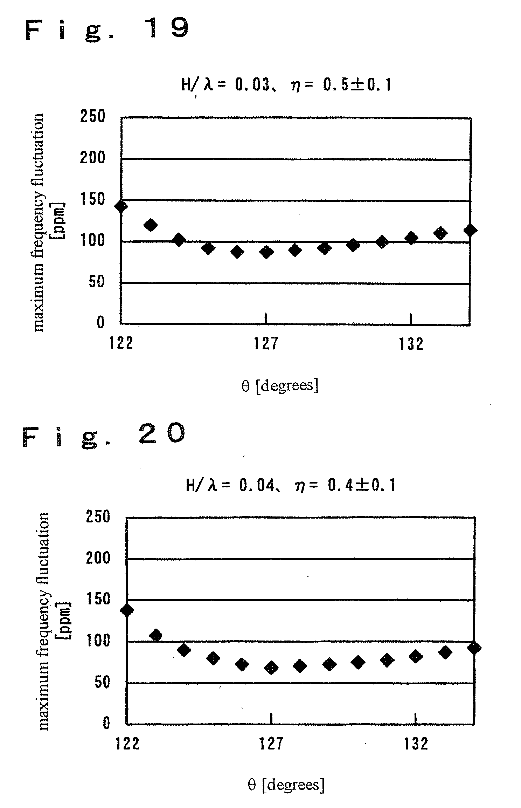

Fig. 18 shows the case wherein H/λ = 0.03 and η = 0.4±0.1. Here, the frequency fluctuation is lowered to less than 100ppm with θ = 123 - 134°. Fig. 19 shows the case wherein H/λ = 0.03, η = 0.5±0.1. The frequency fluctuation is lowered to less than 100ppm with θ = 125 - 131°.

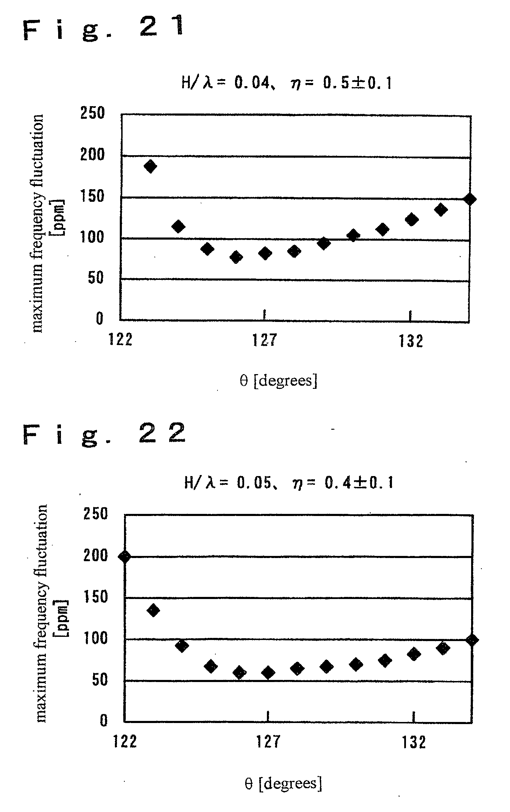

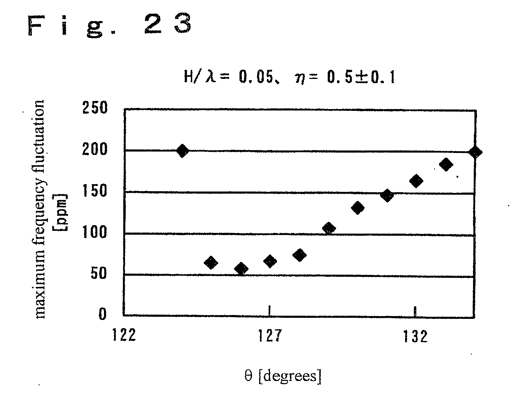

Fig. 20 shows the case wherein H/λ = 0.04 and η = 0.4±0.1. Here, the frequency fluctuation is lowered to less than 100ppm with θ = 124 - 134°. Fig. 21 shows the case wherein H/λ = 0.04 and η = 0.5±0.1; the frequency fluctuation is lowered to less than 100ppm with θ = 125 - 129°. Fig. 22 shows the case wherein H/λ = 0.05 and η = 0.4±0.1; the frequency fluctuation is lowered to less than 100ppm with θ = 124 - 134°. Fig. 23 shows the case wherein H/λ = 0.05 and η = 0.5±0.1; the frequency fluctuation is lowered to less than 100ppm with θ = 125 - 128°.

Consequently, the frequency fluctuation is lowered to less than 100ppm within the temperature range of -40 to +85 °C using θ = 125 - 128° when the manufacturing error is less than 0.2 within η = 0.3 - 0.6.

This range is obviously effective also for the frequency bands for which the electrode width manufacturing error is relatively small (such as 300MHz, 600MHz).

As is described above, the present invention provides a method for adjusting the temperature-dependent property of a SAW device using an in-plane rotated ST cut quartz crystal plate having the Euler's angles of (0°, 113 - 135°, ±(40 - 49°)), wherein the range of Euler's angles is determined so that the temperature-dependent property of the SAW device using an in-plane rotated ST cut quarts crystal plate having the temperature-dependent property expressed by a cubic function has an extreme value. Further, the temperature-dependent property is rotated about the inflection point to minimize the frequency fluctuation within the operation temperature range. Therefore, the oscillation frequency fluctuation can be minimized regardless of the ambient temperature changes.

## Claims

1. A method for adjusting the temperature-dependent property of a surface acoustic wave device using an in-plane rotated ST cut quartz crystal plate having the Euler's angles of (0°, 113 - 135°, ±(40 - 49°)), wherein the temperature-dependent property expressed by a cubic function of the temperature is adjusted by rotating the temperature-dependent property about the inflection point.

2. The method according to Claim 1, wherein the range of Euler's angles is determined so that said temperature-dependent property has an extreme value and, then, said temperature-dependent property is rotated about the inflection point to minimize fluctuation of the temperature-dependent property in an operation temperature range.

3. The method according to Claim 1 or 2, wherein, when the Euler's angles are (0°, θ, ψ), ψ is in the range of ψ = 0.3295 θ + 3.3318° ± 1.125°.

4. The method according to any of the Claims 1 to 3, wherein, when the Euler's angles are (0°, θ, ψ), θ = 125 - 128°, and η is 0.3 - 0.6, η being the width/pitch ratio of electrodes provided on said crystal plate.

5. The method according to any of the Claims 1 to 4, wherein the temperature-dependent property around the inflection point is modified by adjusting the thickness of electrode deposits of the SAW device.

6. The method according to any of the Claims 1 to 4, wherein the temperature-dependent property around the inflection point is modified by rotating the quartz crystal in a plane about the Z' axis.

7. The method according to any of the Claims 1 to 4, wherein the temperature-dependent property around the inflection point is modified by changing η, η being the width/pitch ratio of electrodes of the SAW device.
